# EUROPÄISCHE PATENTANMELDUNG

(11) **EP 0 945 730 A2**
(43) Veröffentlichungstag der Anmeldung: **29.09.1999**
(21) Anmeldenummer: 99100910.1
(22) Anmeldetag: 20.01.1999
(51) Int. Cl.: G01R 15/24, G01R 15/16

(54) **Gasisolierte, metallgekapselte Schaltanlage**

(30) Priorität: 24.03.1998 DE 19812799
(71) Anmelder: ABB PATENT GmbH, 68309 Mannheim (DE)
(72) Erfinder: Rees, Volker, Dr.-Ing., 64289 Darmstadt (DE); Schwarz, Michael, Dipl.-Ing., 63579 Freigericht (DE); Körber, Franz-Josef, Dipl.-Ing., 63674 Altenstadt (DE); Ebbinghaus, Dirk, Dipl.-Ing., 44536 Lünen (DE); Glock, Jürgen, Dipl.-Ing., 69493 Hirschberg (DE)
(74) Vertreter: Miller, Toivo

(57) **Zusammenfassung**

Eine gasisolierte, metallgekapselte, elektrische Schaltanlage mit einem zwischen Hochspannung und Erdpotential angeordneten optischen Spannungssensor in Form eines optischen, den Pockelseffekt ausnutzenden Meßelementes aus lichtleitendem, die Polarisationsebene bei Anlegen einer Spannung veränderndem isolierendem Material ist dadurch gekennzeichnet, daß zur Erzielung einer Eindeutigkeit der vom optischen Spannungssensor (23) abgegebenen Signale wenigstens ein Referenzsignale abgebender kapazitiver Spannungswandler (24) innerhalb der Schaltanlage angeordnet ist.

## Beschreibung

Die Erfindung betrifft eine gasisolierte, metallgekapselte, elektrische Schaltanlage nach dem Oberbegriff des Anspruches 1.

Als Spannungswandler werden oft kapazitive Spannungswandler verwendet. Zwischen Hochspannung und Erdpotential befindet sich eine isolierte Elektrode. Dieses System bildet einen kapazitiven Spannungsteiler. Die in einem gewissen Abstand von der Mellkapselung angeordnete Elektrode bildet mit der Metallkapselung einen Niederspannungskondensator, an dem die Spannung in der Schaltanlage abgenommen werden kann. Derartige konventionelle Spannungswandler sind bei Spannungsanstiegen von mehr als 1.000 kV/Mikrosekunde nicht geeignet. Aus diesem Grund werden sog. unkonventionelle Spannungswandler eingesetzt, die beispielsweise den Pockelseffekt ausnutzen. Zu diesem Zweck ist ein für Licht durchsichtiges Isoliermaterial, z. B. ein Quarz, zwischen Hoch- und Erdpotential angeordnet. Durch diesen Quarz wird ein Strahl mit polarisiertem Licht hindurchgeführt, dessen Polarisationsebene bei Anlegen einer Spannung verändert wird. Aus der Änderung der Polarisationsebene kann dann auf den Spannungsverlauf geschlossen werden.

Ein derartiger optischer Spannungssensor basierend auf dem Pockelseffekt ist z. B. aus der DE 196 34 251.1 bekannt geworden. Mit einem derartigen optischen Spannungssensor können Spannungssteilheiten bis zu 2.000 kV/Mikrosekunde bei SF₆-Schaltgeräten bei einer Schalthandlung detektiert werden. Allerdings ist die zugehörige Auswerteelektronik nicht geeignet, solchen Spannungssteilheiten zu folgen. Die derzeit bekannte Elektronik kann höchstens Spannungssteilheiten zwischen 50 bis 100 kV/Mikrosekunde erfassen bzw. diesen folgen. Hieraus ergeben sich Mehrdeutigkeiten, ein Offsetverhalten bzw. Null-Linienverlust. Zwar stabilisiert sich die Anordnung nach einer gewissen Zeit, hierbei etwa nach 10 ms; dieses ist aber unter bestimmten Voraussetzungen nicht tolerabel.

Aufgabe der Erfindung ist es, bei einem optischen Spannungswandler der bekannten Art die Mehrdeutigkeiten auszuschalten.

Diese Aufgabe wird erfindungsgemäß gelöst durch die Merkmale des Anspruches 1.

Der zusätzliche kapazitive Sensor gibt ein Referenzsignal, mit dem die Mehrdeutigkeiten ausgeschlossen werden können. Dieser kapazitive Sensor benötigt eine bestimmte Genauigkeit, die relativ gering sein kann. Wesentlich ist, daß mit dem kapazitiven Sensor die Phasenlage mit hinreichender Genauigkeit detektiert werden kann.

Ein solcher Sensor ist an sich bekannt.

Anhand der Zeichnung, in der ein Ausführungsbeispiel der Erfindung dargestellt ist, sollen die Erfindung sowie weitere vorteilhafte Ausgestaltungen der Erfindung näher erläutert und beschrieben werden.

Es zeigen:
- Fig. 1: eine Schnittansicht durch einen optischen Spannungssensor, wie er z. B. in der DE 196 34 251.1 dargestellt ist, und
- Fig. 2: eine Schnittansicht durch einen kapazitiven Spannungssensor zur Erzeugung eines Referenzsignales.

Innerhalb einer Metallkapselung 10 befinden sich, von denen Anschlußleitungen 12 und 13 zu einem eine Öffnung 14 in der Metallkapselung 10 verschließenden Phasenisolator 15 verlaufen. Durch den Phasenisolator 15 verlaufen Durchführungen 16, die in einem Raum 17 enden, der durch eine Abdeckhaube 18 oberhalb des Phasenisolators 15 gebildet ist. Die Abdeckhaube 18 besitzt eine mit der Öffnung 14 fluchtende Haubenöffnung 19, die mittels eines Deckels 20 verschlossen ist. An der Innenseite der Haube 18 ist in entsprechendem Abstand zu dem Phasenisolator_15 und damit zu dem freien Ende 21 der Abdeckhaube 18, mit der diese auf dem Phasenisolator 15 befestigt ist, ein parallel zu dem Phasenisolator 15 verlaufender Träger 22 angeformt. Zwischen der Durchführung 16 und dem Träger 22 ist ein optischer Spannungssensor 23 angeordnet, so daß dieser optische Spannungssensor zwischen Hochspannungspotential, das auf der Durchführung 16 anliegt, und Erdpotential, das an dem Träger 22 anliegt, angeordnet ist, so daß mit diesem Sensor 23 die Spannung zwischen Hochspannung und Erdpotential detektiert werden kann. Der Sensor ist ein elektrooptischer Sensor, der auf dem Pockelseffekt basiert und in der DE 196 34 251.1 näher beschrieben ist, so daß hier auf diesen Spannungssensor nicht näher eingegangen werden muß.

Dieser Spannungssensor hat eine bestimmte Empfindlichkeit und kann demgemäß Spannungssteilheiten bis zu 2.000 kV/Mikrosekunden detektieren.

Die von dem Spannungssensor 23 abgegebenen Signale werden in einer Elektronik verarbeitet, die nicht näher dargestellt ist. Da diese Elektronik nur eine geringe Spannungssteilheit verarbeiten kann, in einer konkreten Ausführung bis zu 50 bis 100 kV/Mikrosekunde, erhält man Mehrdeutigkeiten bei der Auswertung, ein Offsetverhalten bzw. einen Null-Linienverlust. Zwar stabilisiert sich die Anordnung, so daß nach einer gewissen Zeit (hier 10 ms) die Anzeigen wieder eindeutig sind; für bestimmte Zwecke ist dies aber nicht geeignet. Aus diesem Grund wird ein kapazitiver Spannungssensor 24 vorgesehen, der an dem Träger 22 befestigt ist und der auf Niederspannungspotential befindliche Spannungsänderungen detektiert. In einer konkreten Ausführung kann dieser Spannungssensor 20 kV detektieren, wobei er eine Meßungenauigkeit von ± 10 kV besitzt.

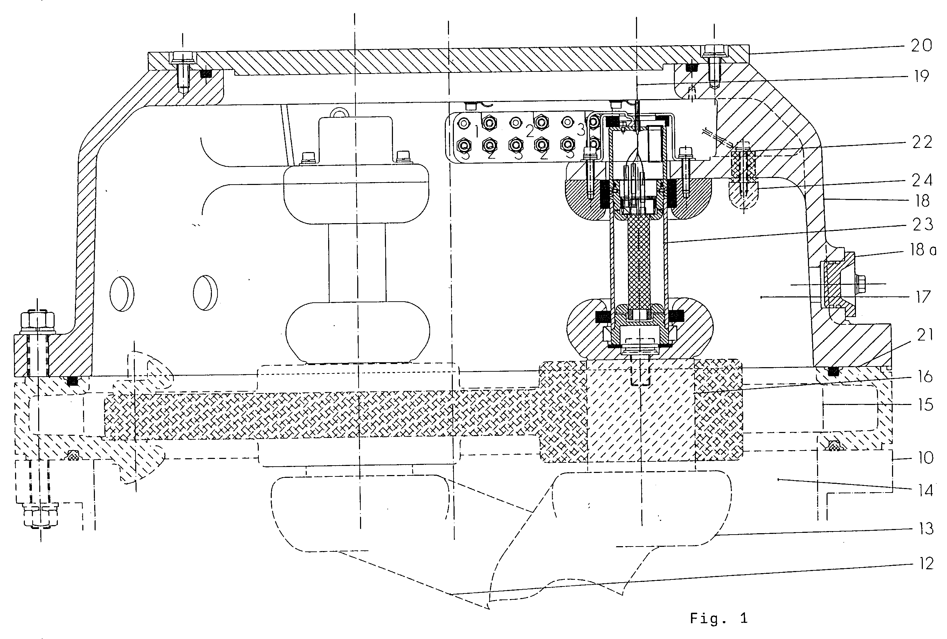

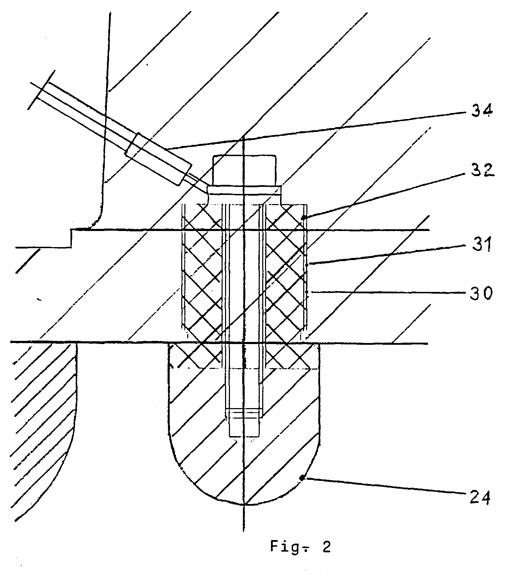

Der nähere Aufbau des Spannungssensors 24 ist der Fig. 2 zu entnehmen. Am Träger 22 ist ein Durchbruch 30 mit einem Gewinde 31 vorgesehen. In dieses Gewinde 31 wird ein Isolierträger 32 eingeschraubt, der den eigentlichen kapazitiven Spannungssensor 24 trägt. An dem Spannungssensor 24 ist ein Signalkabel 34 angeschlossen.

Mit diesem kapazitiven Spannungssensor, der ein handelsüblicher sehr preisgünstiger Spannungssensor ist, wird ein Referenzsignal abgegeben, welches dem Signal von dem optischen Spannungswandler 23 überlagert wird, so daß eine Eindeutigkeit bei dem verarbeiteten Signal erzeugt wird; Null-Linienverlust, Offsetverhalten und Mehrdeutigkeiten sind damit vermieden.

Der Spannungssensor 24 ist im Bereich des Trägers 22 gezeichnet; es besteht natürlich auch die Möglichkeit, daß der Spannungssensor 24 im Bereich der Seitenwand 18a angeordnet sein kann, beispielsweise in der Nähe des Schottisolators 15.

## Patentansprüche

1. Gasisolierte, metallgekapselte, elektrische Schaltanlage mit einem zwischen Hochspannung und Erdpotential angeordneten optischen Spannungssensor in Form eines optischen, den Pockelseffekt ausnutzenden Meßelementes aus lichtleitendem, die Polarisationsebene bei Anlegen einer Spannung veränderndem, isolierendem Material, dadurch gekennzeichnet, daß zur Erzielung einer Eindeutigkeit der vom optischen Spannungssensor (23) abgegebenen Signale wenigstens ein Referenzsignale abgebender kapazitiver Spannungswandler (24) innerhalb der Schaltanlage angeordnet ist.
